# EUROPEAN PATENT APPLICATION

(11) **EP 4 783 790 A1**
(43) Date of publication of application: **29.07.2026**
(21) Application number: 25203311.3
(22) Date of filing: 19.09.2025
(51) Int. Cl.: H10H 20/84, H10H 20/841, H10H 20/857, H10H 29/14, H10H 20/01

(54) **SEMICONDUCTOR LIGHT EMITTING DEVICE**

(30) Priority: 24.01.2025 KR 20250011220
(71) Applicant: Samsung Electronics Co., Ltd., Suwon-si, Gyeonggi-do 16677 (KR)
(72) Inventor: JEONG, Junseok, 16677 Suwon-si, Gyeonggi-do (KR); KWAK, Junghee, 16677 Suwon-si, Gyeonggi-do (KR); KIM, Donggyu, 16677 Suwon-si, Gyeonggi-do (KR); HAN, Jintae, 16677 Suwon-si, Gyeonggi-do (KR)
(74) Representative: Kuhnen & Wacker Patent- und Rechtsanwaltsbüro PartG mbB

(57) **Abstract**

A semiconductor light emitting device (100) includes a first LED cell (110B) including a first semiconductor layer (112) of a first conductivity-type, a first active layer (114B), and a second semiconductor layer (116) of a second conductivity-type; a second LED cell (110G) including a third semiconductor layer (112) of the first conductivity-type, a second active layer (114G) emitting light of a different wavelength from the first active layer (114B), and a fourth semiconductor layer (116) of the second conductivity-type; a third LED cell (110R) including a fifth semiconductor layer (112) of the first conductivity-type, a third active layer (114R) emitting light of a different wavelength from the first and second active layers (114B, 114G), and a sixth semiconductor layer (116) of the second conductivity-type; a first passivation layer (140B) on a side surface of the first LED cell (110B); and a second passivation layer (140G) on a side surface of the second LED cell (110G) and including a different material from a material of the first passivation layer (140B).

## Description

### BACKGROUND

### 1. Field

Some embodiments of the present disclosure relate to a semiconductor light emitting device and a display device.

### 2. Brief Description of Background Art

Recently, an ultra-small semiconductor light emitting diode (LED) that may be applied to a display device for mobile devices such as a smartphone, an artificial reality (AR) or virtual reality (VR) device, or the like has been demanded. When an LED is applied to a display for mobile devices, it has the advantage of being able to implement low power consumption through high luminous efficiency, thereby increasing battery usage time. As a high degree of resolution is required, an ultra-small LED element (e.g., width of 200 µm or less) is required, and in particular, an even more ultra-small LED element (e.g., width of 20 µm or less) for a display for an AR/VR device in which a distance between the display and eyes is very close, is required.

### SUMMARY

According to some embodiments of the present disclosure, an ultra-small semiconductor light emitting device having improved light extraction efficiency and a display device including the same may be provided.

According to some embodiments of the present disclosure, a semiconductor light emitting device may be provided and include: a first LED cell including a first semiconductor layer of a first conductivity-type, a first active layer configured to emit light of a first wavelength, and a second semiconductor layer of a second conductivity-type different from the first conductivity-type, wherein the first semiconductor layer, the first active layer, and the second semiconductor layer are sequentially stacked; a second LED cell including a third semiconductor layer of the first conductivity-type, a second active layer configured to emit light of a second wavelength different from the first wavelength, and a fourth semiconductor layer of the second conductivity-type, wherein the third semiconductor layer, the second active layer, and the fourth semiconductor layer are sequentially stacked; a third LED cell including a fifth semiconductor layer of the first conductivity-type, a third active layer configured to emit light of a third wavelength different from the first wavelength and the second wavelength, and a sixth semiconductor layer of the second conductivity-type, wherein the fifth semiconductor layer, the third active layer, and the sixth semiconductor layer are sequentially stacked; a first passivation layer on a side surface of the first LED cell; and a second passivation layer on a side surface of the second LED cell, the second passivation layer including a material that is different from a material of the first passivation layer.

According to some embodiments of the present disclosure, a semiconductor light emitting device may be provided and include: a first LED cell configured to emit light of a first wavelength; a second LED cell configured to emit light of a second wavelength different from the first wavelength; a third LED cell configured to emit light of a third wavelength different from the first wavelength and the second wavelength; a first passivation layer on a side surface of the first LED cell; and a second passivation layer on a side surface of the second LED cell, wherein a structure of the second passivation layer is different from a structure of the first passivation layer, or a material of the second passivation layer is different from a material of the first passivation layer.

According to some embodiments of the present disclosure, a display device may be provided and include: a circuit board including driving circuits; and a pixel array including a pixel on the circuit board, the pixel including a first sub-pixel, a second sub-pixel, and a third sub-pixel, wherein the first sub-pixel includes a first LED cell, the first LED cell including a first conductivity-type semiconductor layer, a first active layer, and a second conductivity-type semiconductor layer, wherein the second sub-pixel includes a second LED cell, the second LED cell including the first conductivity-type semiconductor layer, a second active layer, and the second conductivity-type semiconductor layer, wherein the third sub-pixel includes a third LED cell, the third LED cell including the first conductivity-type semiconductor layer, a third active layer, and the second conductivity-type semiconductor layer, wherein the pixel array further includes: a first passivation layer on a side surface of the first LED cell; and a second passivation layer on a side surface of the second LED cell, and wherein the second passivation layer includes a material that is different from a material of the first passivation layer.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a cross-sectional view illustrating a semiconductor light emitting device according to example embodiments.
FIG. 2 is a partially enlarged view illustrating a semiconductor light emitting device according to example embodiments.
FIGS. 3A and 3B are cross-sectional views illustrating a semiconductor light emitting device according to example embodiments.
FIG. 4 is a cross-sectional view illustrating a semiconductor light emitting device according to example embodiments.
FIGS. 5A, 5B, 5C, 5D, 5E, 5F, 5G, 5H, 5I, 5J, and 5K are cross-sectional views illustrating a method of manufacturing a semiconductor light emitting device according to example embodiments.
FIG. 6 is a schematic perspective view of a display device according to example embodiments.
FIG. 7 is a schematic plan view of a display device according to example embodiments.
FIG. 8 is a schematic cross-sectional view of a display device according to example embodiments.
FIG. 9 is a driving circuit diagram implemented in a display device according to example embodiments.
FIG. 10 is a conceptual diagram of an electronic device including a display device according to example embodiments.

### DETAILED DESCRIPTION

Hereinafter, non-limiting example embodiments of the present disclosure will be described with reference to the attached drawings. Hereinafter, terms such as "on," "upper," "upper portion," "upper surface," "below," "lower," "lower portion," "lower surface," and "side surface," or the like can be understood to refer to the drawings unless otherwise explained.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

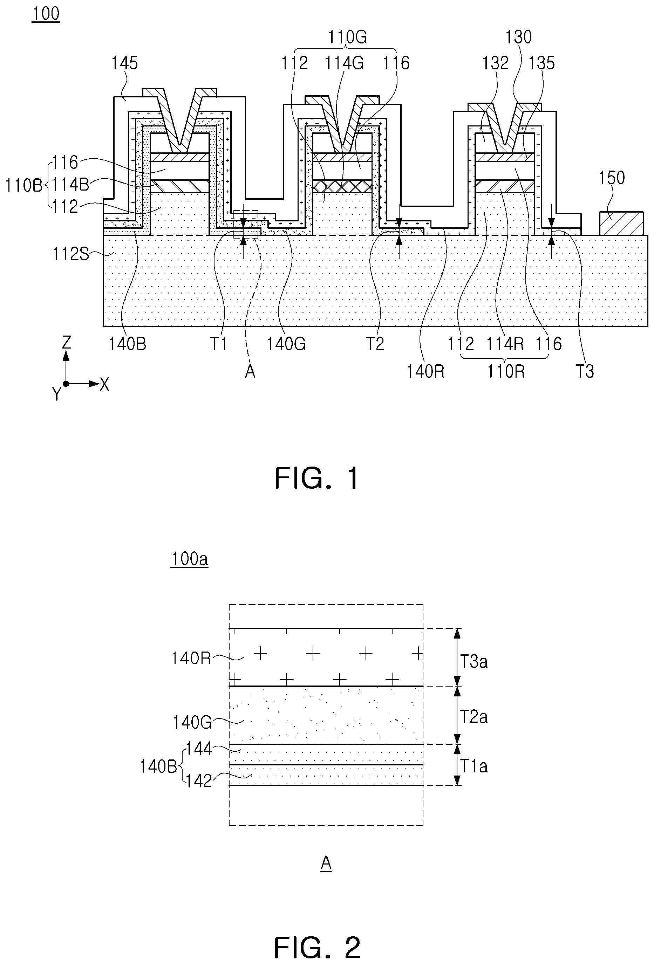

FIG. 1 is a cross-sectional view illustrating a semiconductor light emitting device according to example embodiments.

Referring to FIG. 1, a semiconductor light emitting device 100 may include a first LED cell 110B, a second LED cell 110G, and a third LED cell 110R configured to emit light of different wavelengths from each other, a first passivation layer 140B, a second passivation layer 140G, and a third passivation layer 140R contacting the first to third LED cells 110B, 110G, and 110R, respectively, a fourth passivation layer 145 on the first to third passivation layers 140B, 140G, and 140R, a first electrode 150, and second electrodes 130. The semiconductor light emitting device 100 may further include hard mask layers 132 and a first conductivity-type base semiconductor layer 112S.

Each of the first to third LED cells 110B, 110G, and 110R may have a columnar shape or a rod shape. The first to third LED cells 110B, 110G, and 110R may have a tetragonal shape or a circular shape in a plane. In an example embodiment, the first LED cell 110B may generate blue light such as, for example, light having a wavelength in a range of about 440 nm to about 480 nm. The second LED cell 110G may generate green light such as, for example, light having a wavelength in a range of about 510 nm to about 550 nm. The third LED cell 110R may generate red light such as, for example, light having a wavelength in a range of about 610 nm to about 650 nm. In example embodiments, light emitted by each of the first to third LED cells 110B, 110G, and 110R may be different from each other.

The first LED cell 110B may include a first conductivity-type semiconductor layer 112, a first active layer 114B, and a second conductivity-type semiconductor layer 116, sequentially stacked on the first conductivity-type base semiconductor layer 112S. The second LED cell 110G may include a first conductivity-type semiconductor layer 112, a second active layer 114G, and a second conductivity-type semiconductor layer 116, sequentially stacked on the first conductivity-type base semiconductor layer 112S. The third LED cell 110R may include a first conductivity-type semiconductor layer 112, a third active layer 114R, and a second conductivity-type semiconductor layer 116, sequentially stacked on the first conductivity-type base semiconductor layer 112S. In each of the first to third LED cells 110B, 110G, and 110R, the first conductivity-type semiconductor layer 112, one of the first to third active layers 114B, 114G, and 114R, and the second conductivity-type semiconductor layer 116 may have side surfaces coplanar with each other.

The first conductivity-type semiconductor layer 112, the first to third active layers 114B, 114G, and 114R, and the second conductivity-type semiconductor layer 116 may each be formed of a nitride semiconductor, and may be an epitaxial layer. The first conductivity-type semiconductor layer 112 and the second conductivity-type semiconductor layer 116 may be nitride semiconductor layers having compositions of n-type and p-type InₓAl_{y}Ga_{1-x-y}N (0≤x<1, 0≤y<1, 0≤x+y<1), respectively. For example, the first conductivity-type semiconductor layer 112 may be an n-type gallium nitride (n-GaN) layer doped with silicon (Si), germanium (Ge), or carbon (C), and the second conductivity-type semiconductor layer 116 may be a p-type gallium nitride (p-GaN) layer doped with magnesium (Mg) or zinc (Zn). According to embodiments, the first conductivity-type semiconductor layer 112 and the second conductivity-type semiconductor layer 116 may also be formed as a semiconductor layer of aluminum indium gallium phosphide (AlInGaP) or aluminum indium gallium arsenide (AlInGaAs) series in addition to the nitride semiconductor. Each of the first conductivity-type semiconductor layer 112 and the second conductivity-type semiconductor layer 116 may be formed as a single layer, but may also include a plurality of layers having different characteristics from each other such as a doping concentration, a composition, or the like.

The first conductivity-type semiconductor layers 112 of the first to third LED cells 110B, 110G, and 110R may have a doping concentration(s) and/or a composition(s), identical to each other or different from each other. The second conductivity-type semiconductor layers 116 of the first to third LED cells 110B, 110G, and 110R may have a doping concentration(s) and/or a composition(s), identical to each other or different from each other. In the present disclosure, the first conductivity-type semiconductor layers 112 of the first to third LED cells 110B, 110G, and 110R may be referred to in different manners from each other, and the second conductivity-type semiconductor layers 116 of the first to third LED cells 110B, 110G, and 110R may also be referred to in different manners from each other.

The first conductivity-type base semiconductor layer 112S may be a layer connected to the first conductivity-type semiconductor layers 112 of the first to third LED cells 110B, 110G, and 110R, and may be a base semiconductor layer on which the first conductivity-type semiconductor layers 112 are grown. In some embodiments, the first conductivity-type base semiconductor layer 112S may be removed during a manufacturing process of the semiconductor light emitting device 100.

The first to third active layers 114B, 114G, and 114R may emit light having a predetermined energy by recombination of an electron and a hole. The first to third active layers 114B, 114G, and 114R may have different compositions to emit light of different wavelengths from each other. The first to third active layers 114B, 114G, and 114R may have a single (SQW) structure or a multiple quantum well (MQW) structure in which a quantum barrier layer and a quantum well layer are alternately disposed. For example, the quantum well layer and the quantum barrier layer may be InₓAl_{y}Ga_{1-x-y}N (0≤x≤1, 0≤y≤1, 0≤x+y≤1) layers having different compositions. For example, the quantum well layer may be an InₓGa₁₋ₓN (0<x≤1) layer, and the quantum barrier layer may be a GaN layer or an AlGaN layer.

The first electrode 150 may be disposed on one surface of the first conductivity-type base semiconductor layer 112S. The first electrode 150 may be connected to each of the first conductivity-type semiconductor layers 112 through the first conductivity-type base semiconductor layer 112S. In example embodiments, an arrangement and a shape of the first electrode 150 may be variously changed.

Contact layers 135 and the second electrodes 130 may be disposed sequentially on upper surfaces of the second conductivity-type semiconductor layers 116, and may be connected to the second conductivity-type semiconductor layers 116. Each of the contact layers 135 may be, for example, disposed to entirely cover an upper surface of a respective one of the second conductivity-type semiconductor layers 116. In this case, a side surface of each of the contact layers 135 may be coplanar with a side surface of the second conductivity-type semiconductor layer 116. The second electrodes 130 may penetrate through the fourth passivation layer 145, and may penetrate through the first to third passivation layers 140B, 140G, and 140R and the hard mask layers 132 therebelow, to be connected to the contact layers 135. The second electrodes 130 may be connected to the second conductivity-type semiconductor layers 116 through the contact layers 135. The second electrodes 130 are illustrated as being disposed on different vertical levels from each other, but are not limited thereto. In some embodiments, upper surfaces of the second electrodes 130 may be located on substantially the same vertical level as each other. In some embodiments, the second electrodes 130 may be omitted, in which case the contact layers 135 may be referred to as second electrodes.

The first electrode 150, the contact layers 135, and the second electrodes 130 may include transparent electrode materials and/or highly reflective metals, and may include, for example, at least one from among silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), In₄Sn₃O₁₂, and Zn₍₁₋ₓ₎MgₓO (Zinc Magnesium Oxide, 0≤x≤1).

The hard mask layers 132 may be respectively disposed on the contact layers 135. Each of the hard mask layers 132 may have a side surface coplanar with the side surface of the contact layer 135. The hard mask layers 132 may include an insulating material such as, for example, silicon oxide, silicon nitride, or silicon oxynitride. In some embodiments, the hard mask layers 132 may be omitted.

The first to third passivation layers 140B, 140G, and 140R may respectively cover a portion of the upper surfaces of the hard mask layers 132 and side surfaces of the first to third LED cells 110B, 110G, and 110R. The first to third passivation layers 140B, 140G, and 140R may extend horizontally along an upper surface of the first conductivity-type base semiconductor layer 112S around the first to third LED cells 110B, 110G, and 110R.

The first passivation layer 140B may entirely cover a side surface of the first LED cell 110B, and may cover the side surface of the contact layer 135 and a side surface of the hard mask layer 132 on the first LED cell 110B. The second passivation layer 140G may entirely cover a side surface of the second LED cell 110G, and may cover the side surface of the contact layer 135 and the side surface of the hard mask layer 132 on the second LED cell 110G. The third passivation layer 140R may entirely cover a side surface of the third LED cell 110R, and may cover the side surface of the contact layer 135 and the side surface of the hard mask layer 132 on the third LED cell 110R.

During an etching process for forming first to third LED cells, defects may occur on the side surfaces of the first to third LED cells, which may cause non-radiative recombination and side leakage current, thereby deteriorating performance of a semiconductor light emitting device of a comparative embodiment. According to an embodiment of the present disclosure, first to third passivation layers 140B, 140G, and 140R may be disposed separately according to emission wavelengths of the first to third LED cells 110B, 110G, and 110R, thereby avoiding or reducing such degradation of performance to improve external quantum efficiency of the first to third LED cells 110B, 110G, and 110R.

Each of the first to third passivation layers 140B, 140G, and 140R may have a substantially uniform thickness, and may conformally extend. The first passivation layer 140B may have an end portion located between the first LED cell 110B and an LED cell adjacent thereto, such as the second LED cell 110G, not to extend onto the second LED cell 110G and the third LED cell 110R. The second passivation layer 140G may extend onto the first LED cell 110B, and may be in contact with a surface including an upper surface of the first passivation layer 140B. The second passivation layer 140G may have an end portion located between the second cell 110G and the third LED cell 110R not to extend onto the third LED cell 110R. Levels of upper surfaces or upper ends of the second passivation layer 140G on the first LED cell 110B and the second LED cell 110G may be different from each other. For example, the level of the upper surface of the second passivation layer 140G may be relatively higher on the first LED cell 110B. The third passivation layer 140R may extend onto the first LED cell 110B and the second LED cell 110G, and may be in contact with a surface including an upper surface of the second passivation layer 140G. Levels of upper surfaces or upper ends of the third passivation layer 140R on the first to third LED cells 110B, 110G, and 110R may be different from each other. For example, the level of the upper surface of the third passivation layer 140R may be highest on the first LED cell 110B, and may be lowest on the third LED cell 110R.

The first to third passivation layers 140B, 140G, and 140R may be different from each other in view of at least one from among a structure or a material. In some embodiments, at least one from among the first to third passivation layers 140B, 140G, and 140R may have a multilayer structure, and at least one other from among the first to third passivation layers 140B, 140G, and 140R may have a single layer structure. In some embodiments, the first to third passivation layers 140B, 140G, and 140R may have a first thickness T1, second thickness T2, and a third thickness T3, respectively, wherein the first thickness T1, the second thickness T2, and the third thickness T3 are different from each other. In some embodiments, the first to third passivation layers 140B, 140G, and 140R may include different materials from each other. In this case, the first to third thicknesses T1, T2, and T3 may be the same, or two or more from among the first to third thicknesses T1, T2, and T3 may be different from each other. Each of the first to third thicknesses T1, T2, and T3 may be in, for example, a range of about 5 nm to about 100 nm.

The first to third passivation layers 140B, 140G, and 140R may include a light-transmitting material and/or an insulating material. The first to third passivation layers 140B, 140G, and 140R may include a metal oxide or a semiconductor oxide. For example, the first to third passivation layers 140B, 140G, and 140R may include at least one from among SiO, SiN, SiCN, SiOC, SiON, SiOCN, HfO, AlO, ZrO, TiO, and AlN. In some embodiments, at least one from among the first to third passivation layers 140B, 140G, and 140R may include a distributed Bragg reflector (DBR) layer.

In the semiconductor light emitting device 100, by making structures and/or materials of the first to third passivation layers 140B, 140G, and 140R contacting the side surfaces of the first to third LED cells 110B, 110G, and 110R different, light extraction efficiency of each of the first to third LED cells 110B, 110G, and 110R may be maximized, thereby entirely improving light extraction efficiency of the semiconductor light emitting device 100.

The fourth passivation layer 145 may conformally extend on the first to third passivation layers 140B, 140G, and 140R. A thickness of the fourth passivation layer 145 may be greater than each of the first to third thicknesses T1, T2, and T3. For example, a thickness of the fourth passivation layer 145 may be in a range from about 50 nm to about 300 nm. The fourth passivation layer 145 may include an insulating material, and may include a material different from at least one of the first to third passivation layers 140B, 140G, and 140R. For example, the fourth passivation layer 145 may include SiO₂. In some embodiments, the fourth passivation layer 145 may be omitted.

FIG. 2 is a partially enlarged view illustrating a semiconductor light emitting device according to example embodiments. FIG. 2 enlarges a region corresponding to a portion A of FIG. 1.

Referring to FIG. 2, in a semiconductor light emitting device 100a, a first passivation layer 140B may have a double layer structure, and each of the second passivation layer 140G and the third passivation layer 140R may each have a single layer structure. The first passivation layer 140B may include a first layer 142 and a second layer 144, vertically stacked and including different materials from each other. For example, the first layer 142 may include AlO, the second layer 144 may include ZrO, and at least one from among the second passivation layer 140G and the third passivation layer 140R may include AlO. In some embodiments, the first passivation layer 140B may include a plurality of first layers 142 and a plurality of second layers 144, and may have a structure in which the first layers 142 and the second layers 144 are alternately stacked. A first thickness T1a of the first passivation layer 140B may be smaller than a second thickness T2a of the second passivation layer 140G and a third thickness T3a of the third passivation layer 140R. The second thickness T2a and the third thickness T3a may be the same as or different from each other.

As such, in example embodiments, the first to third passivation layers 140B, 140G, and 140R may be configured in various manners within a range including different structures and/or materials.

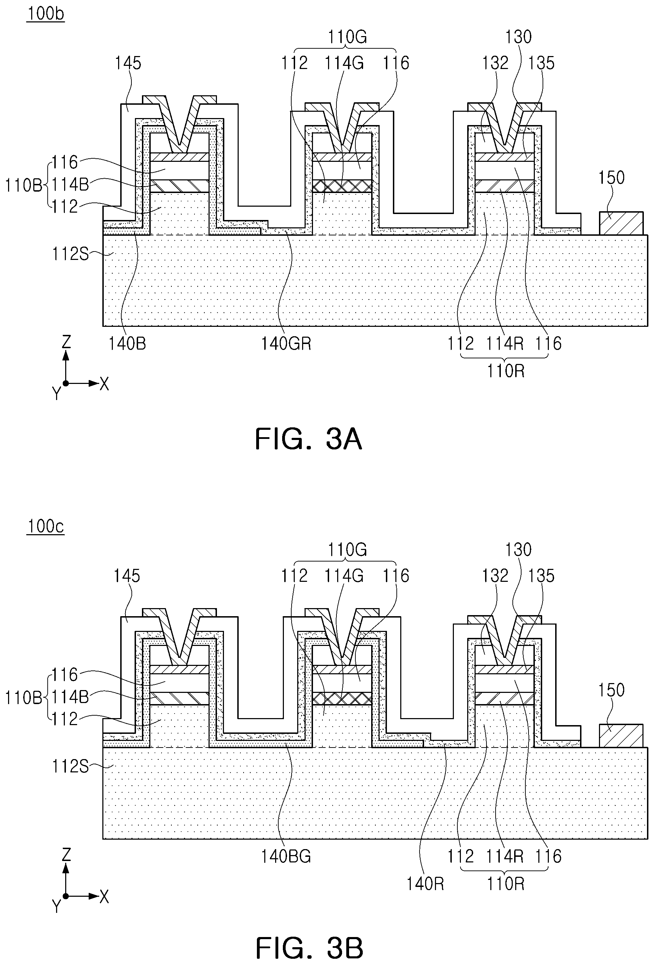

FIGS. 3A and 3B are cross-sectional views illustrating a semiconductor light emitting device according to example embodiments.

Referring to FIG. 3A, a semiconductor light emitting device 100b may include a first passivation layer 140B and a second passivation layer 140GR, unlike the embodiment of FIG. 1. Description of the first passivation layer 140B may be the same as described with reference to FIG. 1. The second passivation layer 140GR may be disposed on entireties of the first to third LED cells 110B, 110G, and 110R, and may cover a side surface of the second LED cell 110G and a side surface of the third LED cell 110R. The second passivation layer 140GR may be commonly applied to the second LED cell 110G and the third LED cell 110R. The second passivation layer 140GR may be in contact with a portion of the first passivation layer 140B on the first LED cell 110B. The first passivation layer 140B and the second passivation layer 140GR may have different structures and/or materials from each other, as described with reference to FIG. 1.

Referring to FIG. 3B, a semiconductor light emitting device 100c may include a first passivation layer 140BG and a third passivation layer 140R, unlike the embodiment of FIG. 1. The first passivation layer 140BG may be disposed on first LED cell 110B and the second LED cell 110G, and may cover a side surface of the first LED cell 110B and a side surface of the second LED cell 110G. The first passivation layer 140BG may be provided on both the first LED cell 110B and the second LED cell 110G. The third passivation layer 140R may cover a side surface of a third LED cell 110R, and may be in contact with a portion of the first passivation layer 140BG on the first LED cell 110B and the second LED cell 110G. The first passivation layer 140BG and the third passivation layer 140R may have different structures and/or materials from each other, as described with reference to FIG. 1.

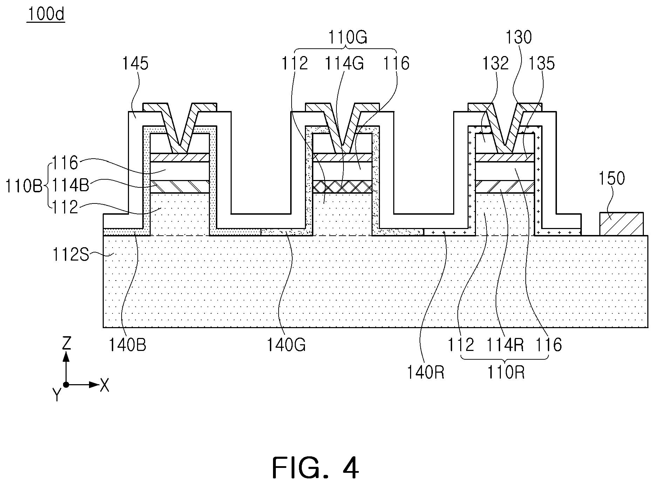

FIG. 4 is a cross-sectional view illustrating a semiconductor light emitting device according to example embodiments.

Referring to FIG. 4, in a semiconductor light emitting device 100d, first to third passivation layers 140B, 140G, and 140R may not extend onto LED cells, other than the first to third LED cells 110B, 110G, and 110R contacting the first to third passivation layers 140B, 140G, and 140R, unlike the embodiment of FIG. 1. End portions of the first to third passivation layers 140B, 140G, and 140R may be located between adjacent first to third LED cells 110B, 110G, and 110R, and may be in contact with each other.

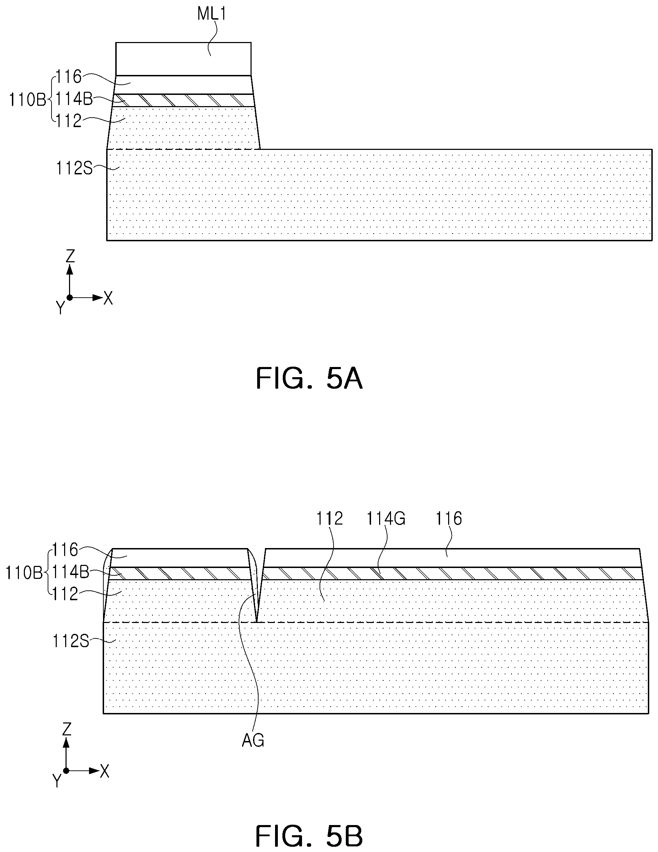

FIGS. 5A to 5K are cross-sectional views illustrating a method of manufacturing a semiconductor light emitting device according to example embodiments. FIGS. 5A to 5K illustrates a method for manufacturing the semiconductor light emitting device according to the embodiment of FIG. 1.

Referring to FIG. 5A, a first conductivity-type semiconductor layer 112, a first active layer 114B, and a second conductivity-type semiconductor layer 116 may be sequentially stacked to form a stack structure on a first conductivity-type base semiconductor layer 112S, and the stack structure may be etched to form a first LED cell 110B.

The first conductivity-type base semiconductor layer 112S may be formed on a separate growth substrate. The growth substrate may be for nitride single crystal growth, and may include, for example, at least one from among sapphire, Si, SiC, MgAl₂O₄, MgO, LiAlO₂, LiGaO₂, and GaN. According to embodiments, to improve crystallinity and light extraction efficiency of the semiconductor layers, the growth substrate may have an uneven structure on at least a portion of an upper surface. In this case, unevenness may also be formed on layers to be grown in an upper portion.

The first conductivity-type base semiconductor layer 112S, the first conductivity-type semiconductor layer 112, the first active layer 114B, and the second conductivity-type semiconductor layer 116 may be formed using, for example, a metal organic chemical vapor deposition (MOCVD) process, a hydride vapor phase epitaxy (HVPE) process, or a molecular beam epitaxy (MBE) process. The first conductivity-type base semiconductor layer 112S and the first conductivity-type semiconductor layer 112 may be n-type nitride semiconductor layers such as n-type GaN, and the second conductivity-type semiconductor layer 116 may be a p-type nitride semiconductor layer such as p-type GaN/p-type AlGaN. The first conductivity-type base semiconductor layer 112S and the first conductivity-type semiconductor layer 112 may have the same impurity concentration or different impurity concentrations. The first active layer 114B may be a multi-quantum well structure such as InGaN/GaN. According to embodiments, the first conductivity-type base semiconductor layer 112S may include a buffer layer. In this case, the buffer layer may be for alleviating lattice defects of the first conductivity-type semiconductor layer 112, and may include an undoped nitride semiconductor such as undoped GaN, undoped AlN, and undoped InGaN.

The stack structure including the first conductivity-type semiconductor layer 112, the first active layer 114B, and the second conductivity-type semiconductor layer 116 may be partially removed using an etching process such as, for example, a dry etching process. The etching process may be performed using a first mask layer ML1. The first mask layer ML1 may be a hard mask layer, and may include, for example, silicon oxide, silicon nitride, or the like.

Thereby, the first LED cell 110B may be formed. In this operation, the first LED cell 110B may be etched to have a relatively wide width and an inclined side surface, as compared to a structure to be finally formed. In some embodiments, a damaged region due to the etching process may be formed on a side surface of the first LED cell 110B by the dry etching process.

Referring to FIG. 5B, a first conductivity-type semiconductor layer 112, a second active layer 114G, and a second conductivity-type semiconductor layer 116 may be sequentially stacked on the first conductivity-type base semiconductor layer 112S.

The first conductivity-type semiconductor layer 112, the second active layer 114G, and the second conductivity-type semiconductor layer 116 may be formed in the same manner as the processes described above with reference to FIG. 5A. The second active layer 114G may be formed to have a different composition from the first active layer 114B such as, for example, a different indium (In) composition. The first conductivity-type semiconductor layer 112 and the second conductivity-type semiconductor layer 116 formed in this operation may have the same composition as or a different composition from the first conductivity-type semiconductor layer 112 and the second conductivity-type semiconductor layer 116, forming the first LED cell 110B, respectively. During the process, a semiconductor layer may also be partially grown on the side surfaces of the first LED cell 110B to form additional growth layers AG. After the process, the first mask layer ML1 may be removed.

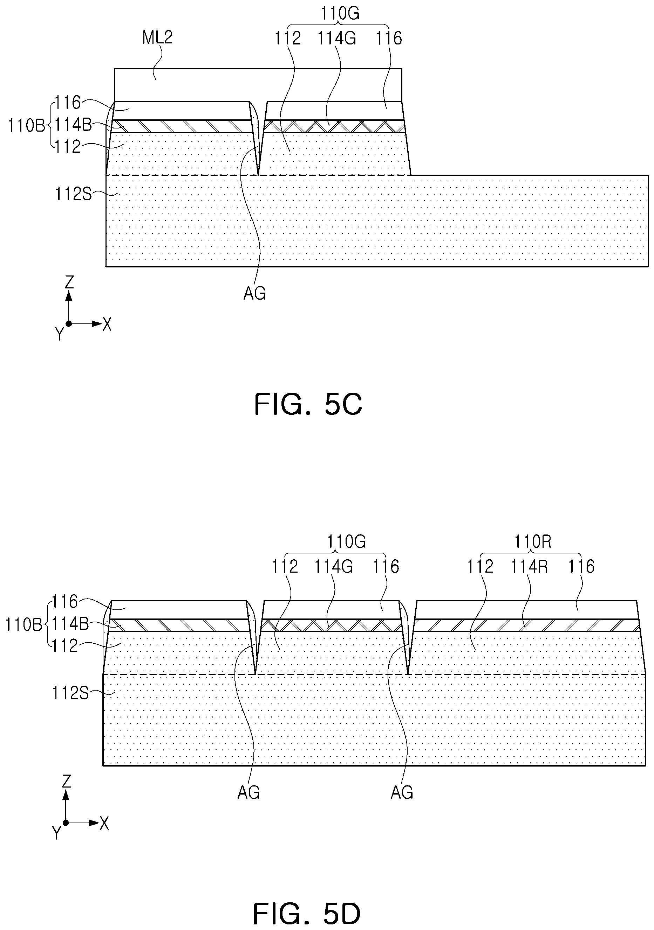

Referring to FIG. 5C, a second LED cell 110G may be formed.

A portion of a stack structure including the first conductivity-type semiconductor layer 112, the second active layer 114G, and the second conductivity-type semiconductor layer 116 may be removed using an etching process such as, for example, a dry etching process. The etching process may be performed using a second mask layer ML2. The second mask layer ML2 may be a hard mask layer, and may include, for example, silicon oxide, silicon nitride, or the like.

Thereby, the second LED cell 110G may be formed. In this operation, the second LED cell 110G may be etched to have a relatively wide width and an inclined side surface, as compared to a structure to be finally formed. In some embodiments, a damaged region due to the etching process may be formed on a side surface of the second LED cell 110G by the dry etching process.

Referring to FIG. 5D, a third LED cell 110R may be formed.

In a similar manner to the first LED cell 110B, and the second LED cell 110G, a first conductivity-type semiconductor layer 112, a third active layer 114R, and a second conductivity-type semiconductor layer 116 may be grown to form the third LED cell 110R. During the process, a semiconductor layer may also be partially grown on the side surface of the second LED cell 110G to form an additional growth layer AG. Thereafter, the second mask layer ML2 may be removed.

An etching process may not be performed in this operation for a stack structure of the first conductivity-type semiconductor layer 112, the third active layer 114R, and the second conductivity-type semiconductor layer 116. In some embodiments, an etching process may also be performed on the stack structure of the first conductivity-type semiconductor layer 112, the third active layer 114R, and the second conductivity-type semiconductor layer 116.

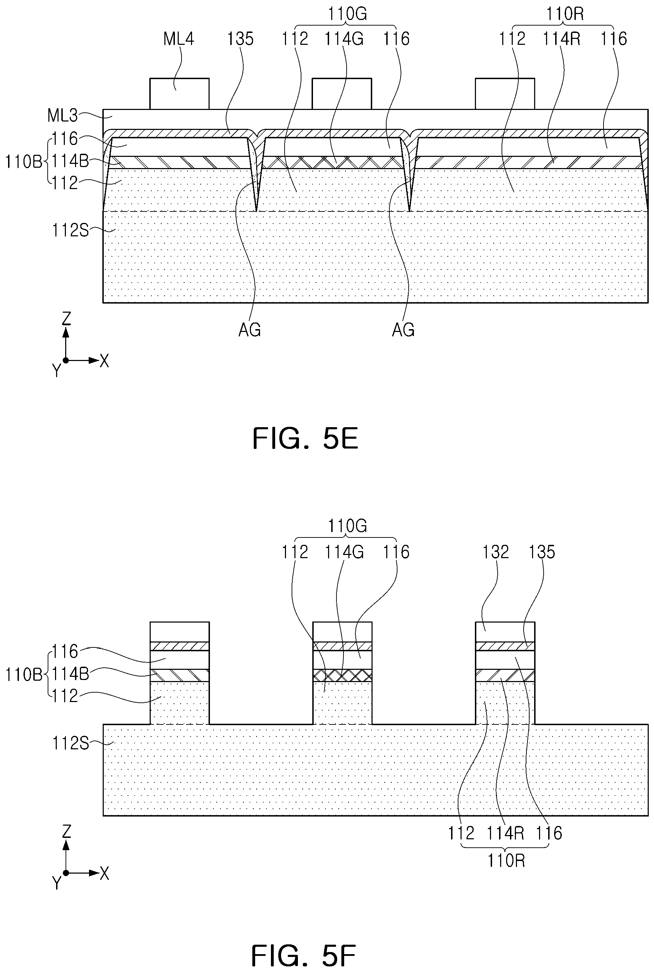

Referring to FIG. 5E, a contact layer 135 may be formed, and a third mask layer ML3 and a fourth mask layer ML4 may be formed.

The contact layer 135 may be conformally formed on the first to third LED cells 110B, 110G, and 110R. The contact layer 135 may include a transparent electrode material, such as, for example, ITO, IZO, or GAZO.

The third mask layer ML3 and the fourth mask layer ML4 may be sequentially formed on the contact layer 135. The third mask layer ML3 may be a hard mask layer, and may include, for example, silicon oxide, silicon nitride, or the like. The fourth mask layer ML4 may be, for example, a photoresist layer.

Referring to FIG. 5F, an etching process may be performed on the first to third LED cells 110B, 110G, and 110R, and the contact layer 135.

The etching process may include two-operation etching processes. A dry etching process may be performed first, and then a wet etching process may be performed. As a result, the additional growth layers AG formed on the side surfaces of the first to third LED cells 110B, 110G, and 110R, and the damaged regions may be removed, and angles between the upper surfaces and the side surfaces of the first to third LED cells 110B, 110G, and 110R may be vertical or close to vertical. In some embodiments, the wet etching process may be omitted, in which case, the first to third LED cells 110B, 110G, and 110R may have inclined side surfaces.

After the etching process, the fourth mask layer ML4 may be removed. The third mask layer ML3 may remain on each of the first to third LED cells 110B, 110G, and 110R to form hard mask layers 132. In some embodiments, the third mask layer ML3 may also be completely removed.

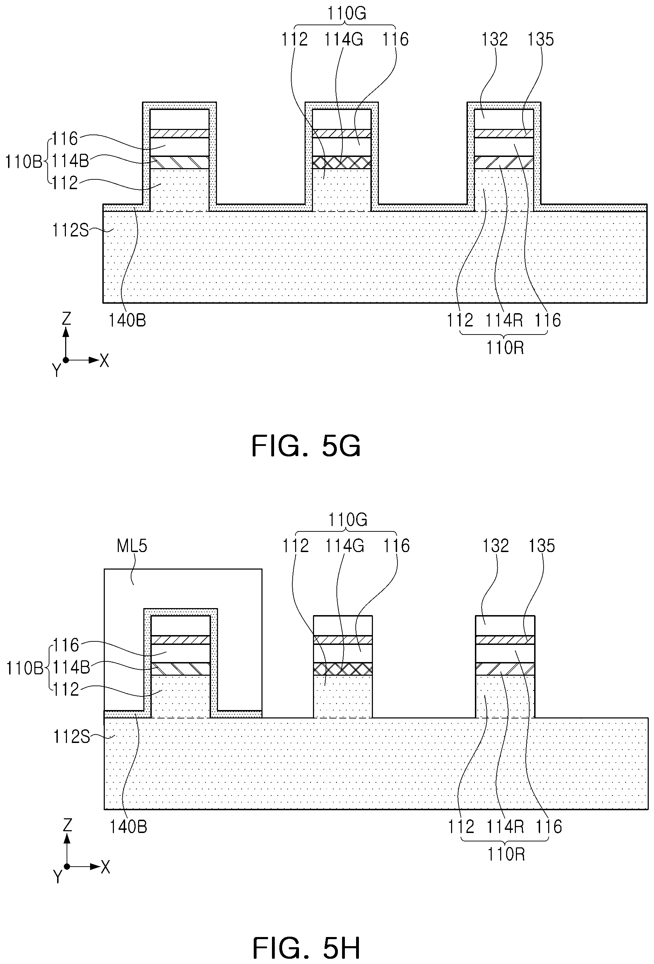

Referring to FIG. 5G, a first passivation layer 140B covering the first to third LED cells 110B, 110G, and 110R, the contact layers 135, and the hard mask layers 132 may be formed.

The first passivation layer 140B may be conformally formed on an entire structure including the first to third LED cells 110B, 110G, and 110R by a deposition process such as, for example, an atomic layer deposition (ALD) process.

Referring to FIG. 5H, the first passivation layer 140B may be partially removed.

A fifth mask layer ML5 may be formed on the first LED cell 110B, and portions of the first passivation layer 140B on the second LED cell 110G and the third LED cell 110R may be removed. The fifth mask layer ML5 may be, for example, a photoresist layer. Therefore, the first passivation layer 140B may be only in contact with the side surface of the first LED cell 110B among the first to third LED cells 110B, 110G, and 110R. After the process, the fifth mask layer ML5 may be removed.

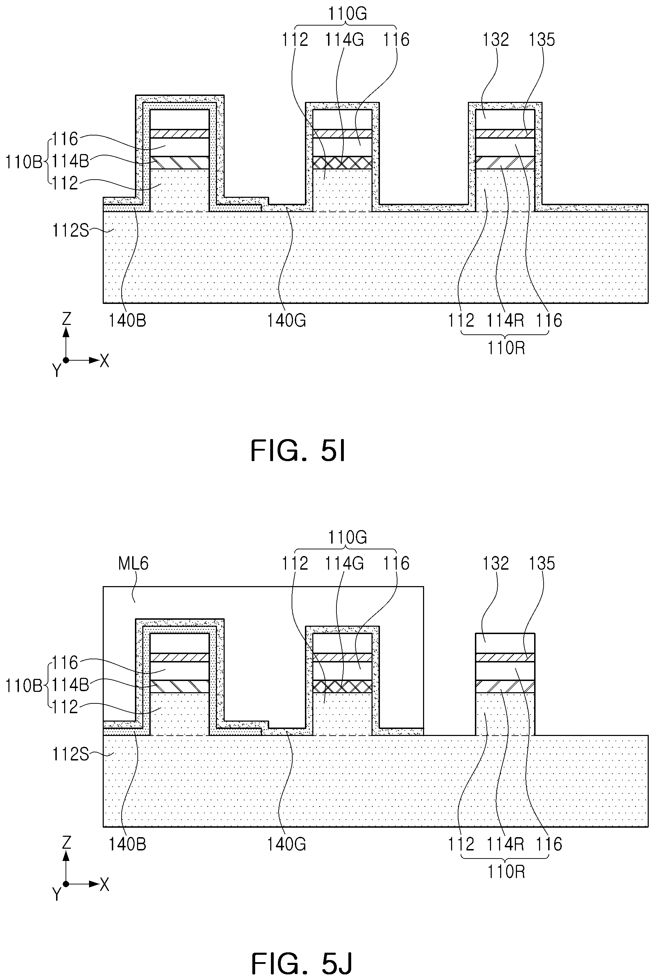

Referring to FIG. 5I, a second passivation layer 140G covering the first to third LED cells 110B, 110G, and 110R, the contact layers 135, and the hard mask layers 132 may be formed.

The second passivation layer 140G, in a similar manner to the first passivation layer 140B, may be conformally formed on the entire structure including the first to third LED cells 110B, 110G, and 110R by a deposition process such as, for example, an ALD process. The second passivation layer 140G may cover and be in contact with the side surfaces of the second LED cell 110G and the third LED cell 110R.

Referring to FIG. 5J, the second passivation layer 140G may be partially removed.

A sixth mask layer ML6 may be formed on the first LED cell 110B and the second LED cell 110G, and a portion of the second passivation layer 140G on the third LED cell 110R may be removed. The sixth mask layer ML6 may be, for example, a photoresist layer. Therefore, the second passivation layer 140G may only be in contact with the side surface of the second LED cell 110G among the first to third LED cells 110B, 110G, and 110R. After the process, the sixth mask layer ML6 may be removed.

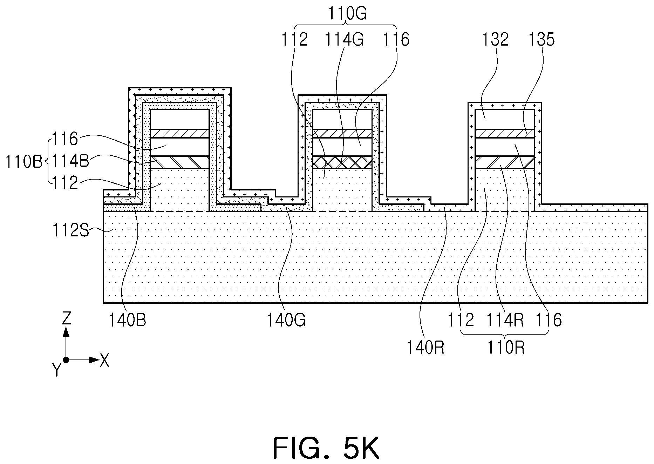

Referring to FIG. 5K, a third passivation layer 140R covering the first to third LED cells 110B, 110G, and 110R, the contact layers 135, and the hard mask layers 132 may be formed.

The third passivation layer 140R may be conformally formed on the entire structure including the first to third LED cells 110B, 110G, and 110R by a deposition process such as, for example, an ALD process, in a similar manner to the first passivation layer 140B. The third passivation layer 140R may cover and contact the side surface of the third LED cell 110R.

Next, referring to FIG. 1, a fourth passivation layer 145 may be formed on the entire structure, and a first electrode 150 and second electrodes 130 may be formed.

The first electrode 150 may be formed on the first conductivity-type base semiconductor layer 112S by partially removing the third passivation layer 140R and the fourth passivation layer 145. The second electrodes 130 may be formed by forming contact holes penetrating the fourth passivation layer 145, the first to third passivation layers 140B, 140G, and 140R, and the hard mask layers 132 and exposing the contact layers 135, and then depositing a conductive material in the contact holes. In this manner, the semiconductor light emitting device 100 of FIG. 1 may be manufactured.

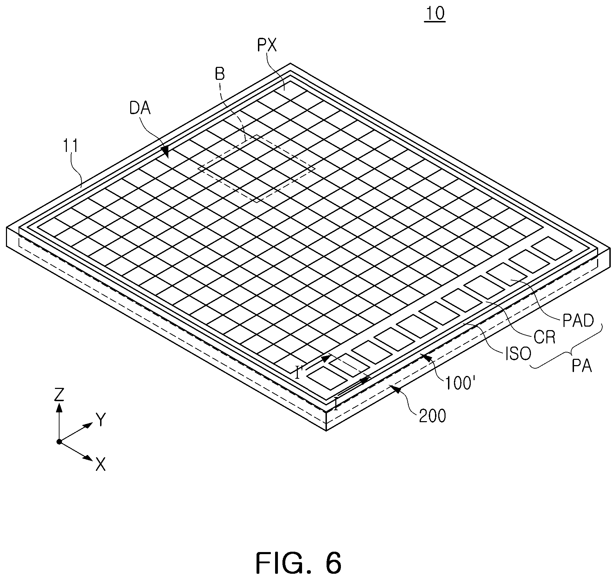

FIG. 6 is a schematic perspective view of a display device according to example embodiments.

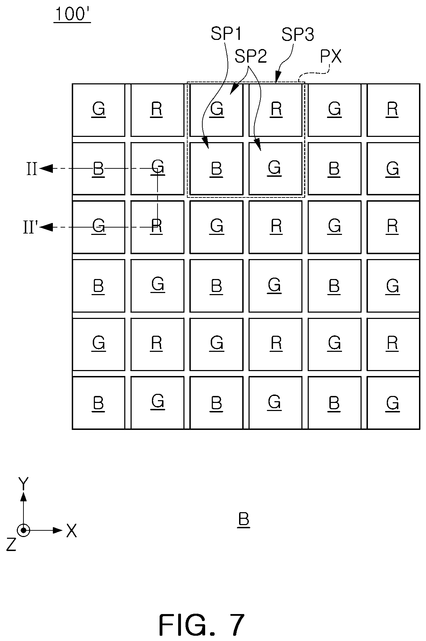

FIG. 7 is a schematic plan view of a display device according to example embodiments. FIG. 7 enlarges a portion B of FIG. 6.

Referring to FIGS. 6 and 7, a display device 10 may include a circuit board 200 including driving circuits, and a pixel array 100' disposed on the circuit board 200 and having a plurality of pixels PX disposed therein. The display device 10 may further include a frame 11 surrounding the circuit board 200 and the pixel array 100'.

The circuit board 200 may be a driving circuit board including thin film transistor (TFT) cells. In some embodiments, the circuit board 200 may include only some of the driving circuits for the display device, in which case the display device 10 may further include other driving devices. In some embodiments, the circuit board 200 may include a flexible board, and the display device 10 may be implemented as a display device having a curved profile.

The pixel array 100' may include a display region DA in which the plurality of pixels PX are disposed, and a peripheral region PA located at least on one side of the display region DA. The peripheral region PA may include pad regions PAD, a connection region CR connecting the plurality of pixels PX and the pad regions PAD, and an edge region ISO.

Each of the plurality of pixels PX may include a first sub-pixel SP1, a second sub-pixel SP2, and a third sub-pixel SP3 configured to emit light of a specific wavelength such as, for example, a specific color, to provide a color image. For example, the first to third sub-pixels SP1, SP2, and SP3 may be configured to emit blue (B) light, green (G) light, and red (R) light, respectively. In each of the pixels PX, the first to third sub-pixels SP1, SP2, and SP3 may be disposed in, for example, a Bayer pattern. Specifically, each of the pixels PX may include the first sub-pixel SP1 and the third sub-pixel SP3 disposed in a first diagonal direction, and two second sub-pixels SP2 disposed in a second diagonal direction, intersecting the first diagonal direction.

In FIG. 7, each of the pixels PX is illustrated as having the first to third sub-pixels SP1, SP2, and SP3 disposed in a 2×2 Bayer pattern, but is not limited thereto, and in other embodiments, each of the pixels PX may be configured in a different arrangement, such as 3×3 or 4×4. In some embodiments, each of the pixels PX may further include a sub-pixel configured to emit a color, other than the colors red (R), green (G), and blue (B), such as, for example, yellow light. In the pixel array 100' of FIG. 6, the plurality of pixels PX may be disposed in a 15×15 configuration, but the number of rows and columns may be implemented as any appropriate number such as, for example, 1,024×768 or the like. For example, depending on a desired resolution, the plurality of pixels PX may have a different arrangement.

The pad regions PAD may be disposed on at least one side of the plurality of pixels PX along an edge of the display device 10. The pad regions PAD may be electrically connected to the plurality of pixels PX and the driving circuits of the circuit board 200. The pad regions PAD may electrically connect the display device 10 to an external device. The connection region CR may be a region located between the plurality of pixels PX and the pad regions PAD. An interconnection structure electrically connected to the plurality of pixels PX such as, for example, a common electrode or the like, may be disposed in the connection region CR. The edge region ISO may be a region along edges of the pixel array 100'.

The frame 11 may be a guide structure surrounding the pixel array 100'. The frame 11 may include at least one material such as a polymer, a ceramic, a semiconductor, or metal. For example, the frame 11 may include a black matrix. The frame 11 is not limited to the black matrix, and may include a white matrix or a structure of another color depending on a purpose of the display device 10. For example, the white matrix may include a reflective material or a scattering material. In FIG. 6, the display device 10 is illustrated as having a tetragonal planar structure, but may have a different shape depending on embodiments.

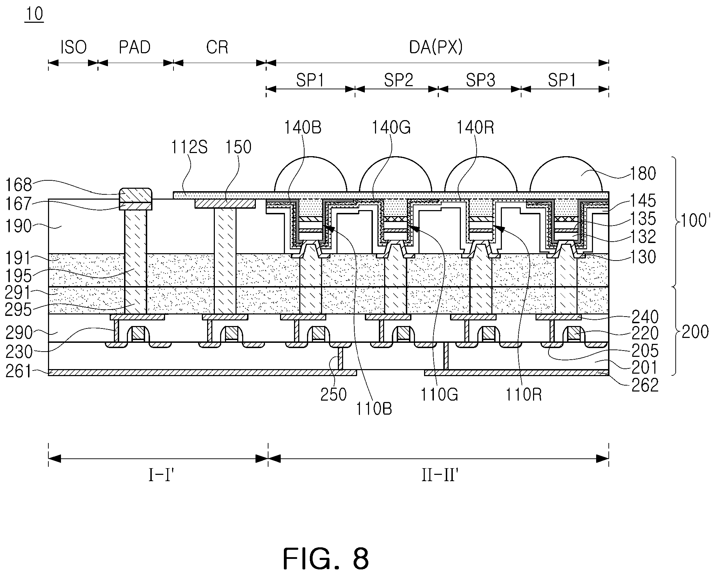

FIG. 8 is a schematic cross-sectional view of a display device according to example embodiments. FIG. 8 illustrates a cross-section along a line I-I' of FIG. 6 and a cross-section along a line II-II' of FIG. 7.

Referring to FIG. 8, the display device 10 may include the circuit board 200 and the pixel array 100' disposed on the circuit board 200.

The circuit board 200 may include a semiconductor substrate 201, a driving circuit including driving elements 220 disposed on the semiconductor substrate 201 and including TFT cells, contact plugs 230 electrically connected to the driving elements 220, circuit interconnection lines 240 on the contact plugs 230, and a circuit insulating layer 290 covering the driving circuit. The circuit board 200 may further include through-electrodes 250 such as through-silicon vias (TSVs) connected to the driving circuit, a first substrate interconnection line 261 and a second substrate interconnection line 262 connected to the through-electrodes 250, a first bonding insulating layer 291 on the circuit insulating layer 290, and first bonding electrodes 295 disposed within the first bonding insulating layer 291 and connected to the circuit interconnection lines 240.

The semiconductor substrate 201 may include impurity regions including source/drain regions 205. The semiconductor substrate 201 may include, for example, a semiconductor such as silicon (Si) or germanium (Ge), or a compound semiconductor such as SiGe, SiC, GaAs, InAs, or InP.

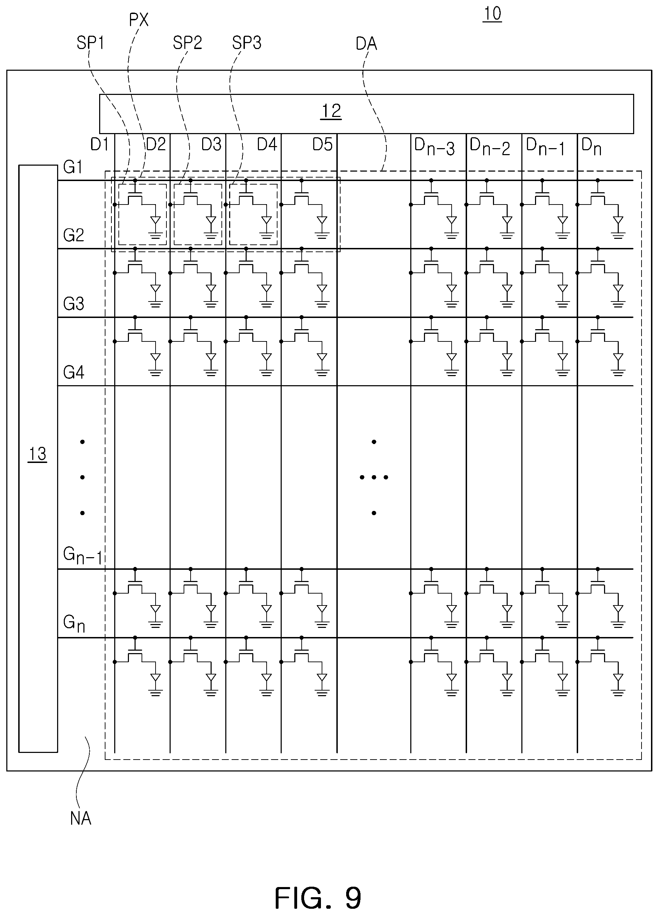

The driving circuit may include a circuit for controlling driving of the pixel, particularly the sub-pixel. The source region of the source/drain region 205 of the TFT cells may be electrically connected to one electrode of LED cells 110 through the contact plug 230, the circuit interconnection line 240, and the first bonding electrode 295. For example, the drain region of the source/drain region 205 of the TFT cells may be connected to the first substrate interconnection line 261 through the through-electrode 250, and the first substrate interconnection line 261 may be connected to a data line. Gate electrodes of the TFT cells may be connected to the second substrate interconnection line 262 through the through-electrode 250, and the second substrate interconnection line 262 may be connected to a gate line. This circuit configuration and operation will be described in more detail with reference to FIG. 9 below.

Upper surfaces of the first bonding electrodes 295 and an upper surface of the first bonding insulating layer 291 may form an upper surface of the circuit board 200. The first bonding electrodes 295 may be bonded to second bonding electrodes 195 of the pixel array 100' to provide an electrical connection path. The first bonding electrodes 295 may include a conductive material such as, for example, copper (Cu). The first bonding insulating layer 291 may be bonded to a second bonding insulating layer 191 of the pixel array 100'. The first bonding insulating layer 291 may include, for example, at least one from among SiO, SiN, SiCN, SiOC, SiON, and SiOCN.

The pixel array 100' may include first to third LED cells 110B, 110G, and 110R, first to third passivation layers 140B, 140G, and 140R respectively contacting the first to third LED cells 110B, 110G, and 110R, a fourth passivation layer 145 on the first to third passivation layers 140B, 140G, and 140R, a first electrode 150 and second electrodes 130 connected to the first to third LED cells 110B, 110G, and 110R, and micro lenses 180. The pixel array 100' may further include contact layers 135 on lower surfaces of the first to third LED cells 110B, 110G, and 110R, an interlayer insulating layer 190 between the first to third LED cells 110B, 110G, and 110R, a first pad electrode 167, a second pad electrode 168, a second bonding insulating layer 191, and second bonding electrodes 195.

The first to third LED cells 110B, 110G, and 110R may form the first to third sub-pixels SP1, SP2, and SP3, respectively, and each of which may form a micro LED. The first to third LED cells 110B, 110G, and 110R may be disposed in columns and rows. Unless otherwise described, description given above with reference to FIG. 1 may be equally applied to the first to third LED cells 110B, 110G, and 110R, the first to third passivation layers 140B, 140G, and 140R, the fourth passivation layer 145, the contact layers 135, the first electrode 150, and the second electrodes 130. In some embodiments, the pixel array 100' may include only two types of LED cells emitting light of different wavelengths such as, for example, the first LED cells 110B and the second LED cells 110G, and may have a structure in which wavelength conversion layers may be further disposed below the micro lenses 180 on some of the first LED cells 110B.

A first conductivity-type base semiconductor layer 112S may be disposed in a form in which at least a portion thereof is removed in the pad region PAD, and may not be disposed in the edge region ISO. The interlayer insulating layer 190 may be disposed to fill a space between the first to third LED cells 110B, 110G, and 110R and spaces between regions of the fourth passivation layer 145. The interlayer insulating layer 190 may include silicon oxide or a silicon oxide-based insulating material.

The micro lenses 180 may be disposed on the first conductivity-type base semiconductor layer 112S, to correspond to (e.g., overlap with) the first to third LED cells 110B, 110G, and 110R, respectively. The micro lenses 180 may collect light incident from the first to third LED cells 110B, 110G, and 110R. The micro lenses 180 may have, for example, a diameter larger than a width of the first to third LED cells 110B, 110G, and 110R in one direction. The micro lenses 180 may include, for example, a transparent photoresist material or a transparent thermosetting resin.

The first electrode 150 may be disposed in the connection region CR. The first electrode 150 may be disposed on a lower surface of the first conductivity-type base semiconductor layer 112S extending from the pixel PX, to connect the first conductivity-type base semiconductor layer 112S to the second bonding electrode 195. In some embodiments, a reflective electrode layer may be further disposed between the first conductivity-type base semiconductor layer 112S and the first electrode 150, and the reflective electrode layer may further extend onto side surfaces of the first to third LED cells 110B, 110G, and 110R.

The first pad electrode 167 and the second pad electrode 168 may be disposed in the pad region PAD. The first pad electrode 167 may be disposed below the second pad electrode 168 in the pad region PAD to connect the second pad electrode 168 and the second bonding electrode 195. The second pad electrode 168 may be connected to an external device, such as an external circuit (e.g., an external integrated circuit (IC)) or the like that may apply an electrical signal to the circuit board 200, by wire bonding or anisotropic conductive film (ACF) bonding. The second pad electrode 168 may electrically connect driving circuits of the circuit board 200 and the external device.

The first pad electrode 167 and the second pad electrode 168 may include at least one of a conductive material such as, for example, silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), silver (Ag), or gold (Au).

The second bonding electrodes 195 may connect the first electrode 150, the second electrodes 130, and the first pad electrode 167 to the first bonding electrodes 295 of the circuit board 200. The second bonding electrodes 195 may be disposed to penetrate through the interlayer insulating layer 190 and the second bonding insulating layer 191. The second bonding electrodes 195 may have a columnar shape, such as a cylinder or the like. According to embodiments, the second bonding electrodes 195 may also have an inclined sidewall such that a size of an upper surface of the second bonding electrodes 195 is smaller than a size of a lower surface of the second bonding electrodes 195. The second bonding electrodes 195 may include, for example, copper (Cu). In some embodiments, the second bonding electrodes 195 may further include a barrier metal layer such as, for example, a tantalum (Ta) layer and/or a tantalum nitride (TaN) layer, on the upper surface and side surfaces of the second bonding electrodes 195.

A lower surface of the second bonding insulating layer 191 may be disposed to form a lower surface of the pixel array 100', together with lower surfaces of the second bonding electrodes 195. The second bonding insulating layer 191 may form a dielectric-to-dielectric bond with the first bonding insulating layer 291. The circuit board 200 and the pixel array 100' may be bonded by bonding the first bonding electrodes 295 and the second bonding electrodes 195 and bonding the first bonding insulating layer 291 and the second bonding insulating layer 191. The bonding of the first bonding electrodes 295 and the second bonding electrodes 195 may be, for example, copper (Cu)-to-copper (Cu) bonding, and the bonding of the first bonding insulating layer 291 and the second bonding insulating layer 191 may be, for example, dielectric-to-dielectric bonding such as SiCN-SiCN bonding. The circuit board 200 and the pixel array 100' may be bonded by hybrid bonding including copper (Cu)-to-copper (Cu) bonding and dielectric-to-dielectric bonding, and may be bonded without a separate adhesive layer.

FIG. 9 is a driving circuit diagram implemented in a display device according to example embodiments.

Referring to FIG. 9, a circuit diagram of a display device 10 in which n×n sub-pixels are disposed is illustrated. First to third sub-pixels SP1, SP2, and SP3 may transmit and receive a data signal through data lines D1 to Dn, which may be paths in a vertical direction (e.g., a column direction). The first to third sub-pixels SP1, SP2, and SP3 may transmit and receive a control signal ( e.g., a gate signal) through gate lines G1 to Gn, which may be paths in a horizontal direction (e.g., a row direction).

A plurality of pixels PX including the first to third sub-pixels SP1, SP2, and SP3 may provide an active region DA for display, and this active region DA may be provided as a display region for a user. An inactive region NA may be formed along one or more edges of the active region DA. The inactive region NA may extend along an outer periphery of a panel of the display device 10, may be a region in which the pixels PX do not exist, and may correspond to a frame 11 (see FIG. 6) of the display device 10.

A first driver circuit 12 and a second driver circuit 13 may be employed to control an operation of the pixels PX (e.g., the first to third sub-pixels SP1, SP2, and SP3). Some or all of the first driver circuit 12 and the second driver circuit 13 may be implemented on a circuit board 200 (see FIG. 6). The first driver circuit 12 and the second driver circuit 13 may be formed as an integrated circuit, a thin film transistor panel circuit, or other suitable circuit, and may be disposed in the inactive region NA of the display device 10. The first driver circuit 12 and the second driver circuit 13 may include a microprocessor, a memory such as storage, a processing circuit, and a communication circuit.

To display an image by the pixels PX, the first driver circuit 12 may supply image data to the data lines D1 to Dn, and may transmit a clock signal and other control signals to the second driver circuit 13, which may be a gate driver circuit. The second driver circuit 13 may be implemented using an integrated circuit and/or a thin film transistor circuit. A gate signal for controlling the first to third sub-pixels SP1, SP2, and SP3 disposed in the row direction may be transmitted through the gate lines G1 to Gn of the display device 10.

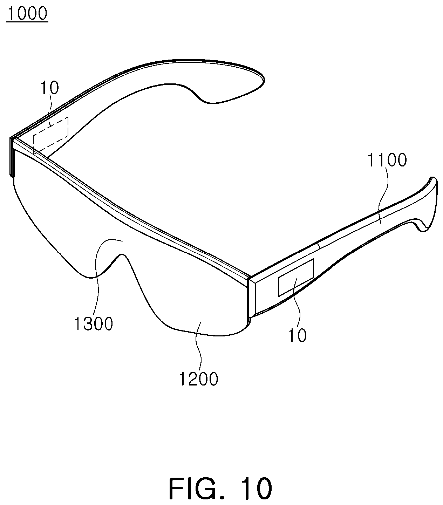

FIG. 10 is a conceptual diagram of an electronic device including a display device according to example embodiments.

Referring to FIG. 10, an electronic device 1000 may be a glasses-type display, which may be a wearable device. The electronic device 1000 may include a pair of temples 1100, a pair of optical coupling lenses 1200, and a bridge 1300. The electronic device 1000 may further include a display device 10 including an image generating unit (e.g., an image generator).

The electronic device 1000 may be a head-mounted, glasses-type, or goggle-type virtual reality (VR) device, augmented reality (AR) device, or mixed reality (MR) device that may provide a virtual reality or may provide a virtual image and an external actual landscape together.

The temples 1100 may extend in parallel and spaced apart from each other. A display device 10 may be disposed within the temples 1100, and projection lenses may be further disposed. The temples 1100 may be folded toward the bridge 1300. The optical coupling lenses 1200 may include a light guide plate, and may further include input/output gratings. The bridge 1300 may be provided between the optical coupling lenses 1200 to connect the optical coupling lenses 1200 to each other.

The display device 10 may be respectively disposed on the temples 1100, and may generate an image on the optical coupling lenses 1200. Specifically, light from the display device 10 may be incident on the projection lenses, and may then be transmitted along the light guide plate of the optical coupling lenses 1200 to generate an image. The display device 10 may be a display device according to the embodiments described above with reference to FIGS. 6 to 9. In some embodiments, the display device 10 may be disposed in a region of the optical coupling lenses 1200.

According to some embodiments of the present disclosure, a method of manufacturing a semiconductor light emitting device may be provided and include: forming a first LED cell, the first LED cell including a first semiconductor layer of a first conductivity-type, a first active layer configured to emit light of a first wavelength, and a second semiconductor layer of a second conductivity-type different from the first conductivity-type, wherein the first semiconductor layer, the first active layer, and the second semiconductor layer are sequentially stacked; forming a second LED cell, the second LED cell including a third semiconductor layer of the first conductivity-type, a second active layer configured to emit light of a second wavelength different from the first wavelength, and a fourth semiconductor layer of the second conductivity-type, wherein the third semiconductor layer, the second active layer, and the fourth semiconductor layer are sequentially stacked; forming a third LED cell, the third LED cell including a fifth semiconductor layer of the first conductivity-type, a third active layer configured to emit light of a third wavelength different from the first wavelength and the second wavelength, and a sixth semiconductor layer of the second conductivity-type, wherein the fifth semiconductor layer, the third active layer, and the sixth semiconductor layer are sequentially stacked; providing a first passivation layer on a side surface of the first LED cell; and providing a second passivation layer on a side surface of the second LED cell, the second passivation layer including a material that is different from a material of the first passivation layer.

According to some embodiments of the present disclosure, the second passivation layer extends onto the first passivation layer.

According to some embodiments of the present disclosure, a vertical level of an upper surface of a portion of the second passivation layer on the first LED cell is different from a vertical level of an upper surface of a portion of the second passivation layer on the second LED cell.

According to some embodiments of the present disclosure, the method further includes forming a third passivation layer on a side surface of the third LED cell, the third passivation layer including a material that is different from the material of the first passivation layer and the material of the second passivation layer.

By applying different passivation layers to LED cells emitting light of different wavelengths, an ultra-small semiconductor light emitting device having improved light extraction efficiency and a display device including the same may be provided.

Various advantages and effects of embodiments of the present disclosure are not limited to the above-described contents, and other advantages and effects of embodiments of the present disclosure would have been understood by a person of ordinary skill in the art based on the above-described contents.

While non-limiting example embodiments of the present disclosure have been described above with reference to the accompanying drawings, it will be apparent to those skilled in the art that modifications and variations could be made without departing from the scope of the present disclosure.

## Claims

1. A semiconductor light emitting device (100, 100a; 100b; 100c; 100d) comprising:
a first light emitting diode, LED, cell (110B) comprising a first semiconductor layer (112) of a first conductivity-type, a first active layer (114B) configured to emit light of a first wavelength, and a second semiconductor layer (116) of a second conductivity-type different from the first conductivity-type, wherein the first semiconductor layer (112), the first active layer (114B), and the second semiconductor layer (116) are sequentially stacked;
a second LED cell (110G) comprising a third semiconductor layer (112) of the first conductivity-type, a second active layer (114G) configured to emit light of a second wavelength different from the first wavelength, and a fourth semiconductor layer (116) of the second conductivity-type, wherein the third semiconductor layer (112), the second active layer (114G), and the fourth semiconductor layer (116) are sequentially stacked;
a third LED cell (110R) comprising a fifth semiconductor layer (112) of the first conductivity-type, a third active layer (114R) configured to emit light of a third wavelength different from the first wavelength and the second wavelength, and a sixth semiconductor layer (116) of the second conductivity-type, wherein the fifth semiconductor layer (112), the third active layer (114R), and the sixth semiconductor layer (116) are sequentially stacked;
a first passivation layer (140B; 140BG) on a side surface of the first LED cell (110B); and
a second passivation layer (140G; 140GR) on a side surface of the second LED cell (110G), the second passivation layer (140G; 140GR) comprising a material that is different from a material of the first passivation layer (140B).

2. The semiconductor light emitting device (100; 100a; 100b) of claim 1, wherein the second passivation layer (140G; 140GR) extends onto the first passivation layer (140B).

3. The semiconductor light emitting device (100, 100a; 100b) of claim 2, wherein a vertical level of an upper surface of a portion of the second passivation layer (140G; 140GR) on the first LED cell (110B) is different from a vertical level of an upper surface of a portion of the second passivation layer (140G; 140GR) on the second LED cell (110G).

4. The semiconductor light emitting device (100, 100a) of claim 2 or 3, wherein the second passivation layer (140G) comprises an end portion between the second LED cell (110G) and the third LED cell (110R), and the second passivation layer (140G) does not extend onto the third LED cell (110R).

5. The semiconductor light emitting device (100, 100a) of any one of claims 1 to 4, further comprising a third passivation layer (140R) on a side surface of the third LED cell (110R), the third passivation layer (140R) comprising a material that is different from the material of the first passivation layer (140B) and the material of the second passivation layer (140G).

6. The semiconductor light emitting device (100, 100a) of claim 5, wherein the third passivation layer (140R) extends onto the first passivation layer (140B) and the second passivation layer (140G).

7. The semiconductor light emitting device (100b) of any one of claims 1 to 3, wherein the second passivation layer (140GR) extends onto the third LED cell (110R) and is on a side surface of the third LED cell (110R).

8. The semiconductor light emitting device (100d) of claim 1, wherein the first passivation layer (140B) comprises an end portion between the first LED cell (110B) and the second LED cell (110G), and the first passivation layer (140B) does not to extend onto the second LED cell (110G) and the third LED cell (110R), and
wherein the second passivation layer (140G) comprises a first end portion between the second LED cell (110G) and the first LED cell (110B), and a second end portion between the second LED cell (110G) and the third LED cell (110R), and the second passivation layer (140G) does not to extend onto the first LED cell (110B) and the third LED cell (110R).

9. The semiconductor light emitting device (100, 100a) of claims 8, further comprising a third passivation layer (140R) on a side surface of the third LED cell (110R), the third passivation layer (140R) comprising a material that is different from the material of the first passivation layer (140B) and the material of the second passivation layer (140G).

10. The semiconductor light emitting device (100, 100a-100d) of any one of claims 1 to 9, wherein the first passivation layer (140B; 140BG) and the second passivation layer (140G; 140GR) comprises at least one from among SiO, SiN, SiCN, SiOC, SiON, SiOCN, HfO, AlO, ZrO, TiO, and AlN.

11. The semiconductor light emitting device (100, 100a-100d) of any one of claims 1 to 10, wherein a thickness of the first passivation layer (140B) is different from a thickness of the second passivation layer (140G).

12. The semiconductor light emitting device (100; 100a-100d) of any one of claims 1 to 11, further comprising:
a first electrode (150) connected to each of the first semiconductor layer (112), the third semiconductor layer (112), and the fifth semiconductor layer (112); and
second electrodes (130) respectively connected to the second semiconductor layer (116), the fourth semiconductor layer (116), and the sixth semiconductor layer (116).

13. The semiconductor light emitting device (100; 100a-100d) of claim 12, further comprising:
a first contact layer(135) between the second semiconductor layer (116) and a first one of the second electrodes (130), wherein a side surface of the first contact layer (135) is coplanar with a side surface of the second semiconductor layer (116);
a second contact layer (135) between the fourth semiconductor layer (116) and a second one of the second electrodes (130), wherein a side surface of the second contact layer (135) is coplanar with a side surface of the fourth semiconductor layer (116); and
a third contact layer (135) between the sixth semiconductor layer (116) and a third one of the second electrodes (130), wherein a side surface of the third contact layer (135) is coplanar with a side surface of the sixth semiconductor layer (116), and
wherein the first passivation layer (140B) is on the side surface of the first contact layer (135), and the second passivation layer (140G) is on the side surface of the second contact layer (135).
